# FASCICULE DE BREVET EUROPEEN

(11) **EP 4 237 761 B1**
(45) Date de publication et mention de la délivrance du brevet: **04.06.2025**
(21) Numéro de dépôt: 21799025.8
(22) Date de dépôt: 25.10.2021
(51) Int. Cl.: F25B 23/00, F28D 15/02, F28D 15/04

(54) **DISPOSITIF DE TRANSFERT THERMIQUE A FLUIDE DE TRAVAIL DIPHASIQUE**
WÄRMEÜBERTRAGER MIT EINEM ZWEIPHASIGEN ARBEITSFLUID
HEAT-TRANSFER DEVICE WITH A TWO-PHASE WORKING FLUID

(30) Priorité: 27.10.2020 FR 2010991
(43) Date de publication de la demande: 06.09.2023
(73) Titulaire: Euro Heat Pipes, 1400 Nivelles (BE)
(72) Inventeur: RIOBOO, Romain, 7022 Hyon (BE); VAN OOST, Stéphane, 1331 Rosières (BE); CHARTIER, Anthony, 5600 Vodecée (BE); MOHAUPT, Mikael, 7070 Mignault (BE)
(74) Mandataire: Plasseraud IP
(86) Numéro de dépôt international: PCT/EP2021/079482
(87) Numéro de publication internationale: WO 2022/090126

(56) Documents cités:
- EP-A1- 2 291 067
- EP-A1- 2 985 556
- US-A- 5 816 313
- US-B1- 7 004 240

## Description

### Domaine technique

La présente invention est relative à un dispositif de transfert thermique à fluide de travail diphasique. La présente invention se rapporte également à un procédé pour diminuer la température du fluide de travail contenu dans la zone liquide de l'évaporateur d'un tel dispositif de transfert thermique à fluide de travail diphasique.

### Technique antérieure

Il est connu de l'art antérieur des dispositifs de transfert thermique à fluide de travail diphasique, adaptés pour extraire de la chaleur depuis une source chaude et pour restituer cette chaleur à une source froide. Pour ce faire, un fluide de travail diphasique circule généralement, entre un évaporateur et un condenseur, dans un circuit généralement clos, au moyen d'un pompage capillaire produit par une structure capillaire de l'évaporateur.

Par ailleurs, il est aussi prévu, dans le circuit de fluide de travail, un volume disponible faisant office de vase d'expansion, appelé dans le métier '*réservoir*'. Deux configurations distinctes sont souvent utilisées, à savoir **LHP** et **CPL** ; dans la configuration **LHP** (« Loop Heat Pipe »), le réservoir est associé physiquement à l'évaporateur, alors que la configuration **CPL** (« Capillary Pumped Loop »), le réservoir est dissocié physiquement de l'évaporateur.

Dans la suite du présent document, on s'intéresse particulièrement à la configuration CPL (« Capillary Pumped Loop »). Dans cette configuration, l'évaporateur et le réservoir ne sont pas couplés thermiquement.

En fonctionnement, une partie de la puissance thermique de la source chaude est transférée à la structure de l'évaporateur et à la structure capillaire, produisant alors une augmentation de la température du fluide de travail en phase liquide, contenu dans une zone dite liquide de l'évaporateur. Le fluide de travail de la zone liquide peut alors être dans un état proche de la saturation ou même dans un état de liquide sur-chauffé. L'augmentation de température du fluide de travail de la zone liquide peut donc produire une évaporation de ce dernier. Dès lors, des bulles de vapeur se forment dans la zone liquide de l'évaporateur.

La présence de telles bulles de vapeur dans la zone liquide de l'évaporateur peut conduire à l'asséchement de la structure capillaire, qui n'est plus alimentée en liquide, et peut mener à un désamorçage du dispositif.

Les documents US 7 004 240-B1 et EP 2 291 067-A1 décrivent des exemples de dispositifs de transfert thermique.

### Résumé

La présente invention vient limiter, voire supprimer, la formation de bulles de vapeur dans la zone liquide de l'évaporateur.

Selon l'invention, comme définie par la revendication indépendante 1 annexée, il est proposé un dispositif de transfert thermique à fluide de travail diphasique, comprenant :
- un évaporateur comportant une zone liquide (e.g. formée notamment par une zone principale et/ou une pluralité de canaux) et une zone vapeur (e.g. comprenant notamment une pluralité de canaux),
- un condenseur ayant au moins une entrée et au moins une sortie,
- un premier circuit de communication, pour du fluide de travail essentiellement en phase vapeur, reliant la zone vapeur de l'évaporateur à au moins une entrée du condenseur,
- un deuxième circuit de communication, pour du fluide de travail essentiellement en phase liquide, reliant au moins une sortie du condenseur à la zone liquide de l'évaporateur,
- un réservoir contenant du fluide de travail avec une phase liquide et une phase vapeur,
- un élément d'apport d'énergie, à commande sélective, adapté pour augmenter la pression du fluide de travail contenu dans le réservoir, le réservoir étant relié uniquement à la zone liquide de l'évaporateur au moyen d'un troisième circuit de communication pour du fluide de travail essentiellement en phase liquide, une portion du troisième circuit de communication étant thermiquement couplée à une première source froide.

Ainsi, lorsque la température du fluide de travail dans la zone liquide de l'évaporateur vient à augmenter, un écoulement de fluide de travail présentant une température inférieure est acheminé dans la zone liquide depuis le réservoir, permettant avantageusement de refroidir le fluide de travail dans la zone liquide et d'y condenser d'éventuelles bulles de vapeur. Un tel dispositif permet également d'éviter un sous-refroidissement du fluide de travail au niveau du condenseur, cela nécessitant un surdimensionnement du condenseur et réduisant aussi les performances du dispositif de transfert thermique.

Sous le terme *« zone liquide »* de l'évaporateur, il faut comprendre un ou plusieurs volumes internes à l'évaporateur (canaux ou autres formes), en communication les uns avec les autres, et pouvant être au contact d'un organe de pompage capillaire. Sous le terme *« zone* vapeur » de l'évaporateur, il faut comprendre un ou plusieurs volumes internes à l'évaporateur (canaux ou autres formes), en communication avec un collecteur en direction d'une sortie, et pouvant être au contact d'un organe de pompage capillaire, l'organe de pompage capillaire étant interposé entre les volumes de la zone liquide et les volumes de la zone vapeur.

Le réservoir peut être agencé à distance de l'évaporateur, notamment dans un environnement thermique distinct. Ainsi, avantageusement, il est possible de réguler thermiquement le fluide de travail dans le réservoir, indépendamment de l'environnement thermique de l'évaporateur. Par ailleurs, la température de saturation du fluide de travail dans le dispositif de transfert thermique est imposée par la température du fluide de travail dans le réservoir. En d'autres termes, la température de régulation du dispositif est imposée par la température du fluide de travail dans le réservoir. Ainsi, cela permet de diminuer et maintenir une température de régulation du dispositif inférieure à la température de l'environnement dans lequel se trouve le dispositif. Cela permet également de disposer de manière indépendante le réservoir et l'évaporateur pour améliorer l'encombrement du dispositif ou encore pour diminuer les éventuels flux thermiques parasites avec le milieu ambient.

Le deuxième circuit de communication peut être raccordé à un premier orifice de la zone liquide et le troisième circuit de communication est raccordé à un deuxième orifice de la zone liquide, le premier orifice étant situé au voisinage d'une première extrémité de la zone liquide et le deuxième orifice étant situé au voisinage d'une deuxième extrémité de la zone liquide. Autrement dit, avantageusement, en considérant l'évaporateur, le premier orifice et le deuxième orifice sont agencés à des positions opposées de la zone liquide.

Ainsi, un apport de fluide de travail refroidi, provenant d'une part du condenseur, et d'autre part du réservoir, est formé dans deux régions opposées de la zone liquide. Le refroidissement du fluide de travail dans la zone liquide est donc plus efficace si on le compare à une configuration à un seul raccordement dans la zone liquide. On note que dans plusieurs conditions opérationnelles, l'apport de fluide de travail refroidi, provenant du réservoir par le troisième circuit de communication, est à une température inférieure à Tsat.

L'évaporateur peut comporter une structure capillaire séparant la zone liquide de la zone vapeur, la structure capillaire étant adaptée au pompage capillaire du fluide de travail en phase liquide. Une telle structure capillaire permet un système de pompage passif, ne nécessitant peu, voire pas, d'entretien, et particulièrement adapté pour les applications spatiales, aéronautiques, ferroviaires.

Le fluide de travail peut être choisi parmi le méthanol, l'acétone, l'eau, l'éthanol, l'éthane, les fluides réfrigérants et l'ammoniac. De tels fluides de travail sont bien adaptés au transport de chaleur tant en gravité qu'en apesanteur.

L'élément d'apport d'énergie au réservoir peut être un élément de chauffage, par exemple une résistance électrique ou une cellule Peltier. Ainsi, un élément d'apport d'énergie de la sorte est facile à commander, par exemple via une commande électrique.

Le dispositif peut comprendre en outre un premier capteur de température du fluide de travail au voisinage d'une première extrémité du troisième circuit de communication, la première extrémité du troisième circuit de communication étant en communication avec la zone liquide de l'évaporateur. On permet ainsi une commande en boucle fermée, fiable et autonome.

Le dispositif peut comprendre un capteur de pression du fluide de travail contenu dans le réservoir.

Le dispositif peut comprendre en outre un deuxième capteur de température du fluide de travail contenu dans le deuxième circuit de communication, de préférence proche de l'évaporateur.

Le dispositif peut comprendre en outre un troisième capteur de température du fluide de travail au voisinage d'une deuxième extrémité du troisième circuit de communication, la deuxième extrémité du troisième circuit de communication étant en communication avec le réservoir.

De tels capteurs permettent une commande plus fine, prenant en compte les paramètres de fonctionnement à plusieurs positions du dispositif de sorte à prendre en compte tous les cas de figure possibles.

Le condenseur est couplé à une source froide, appelée ici une deuxième source froide. Selon un aspect, la première source froide peut être thermiquement indépendante de la deuxième source froide.

Selon un autre aspect, la première source froide peut être thermiquement couplée à la deuxième source froide. En d'autres termes, la première source froide peut être thermiquement reliée à la deuxième source froide, par exemple par l'intermédiaire d'un pont thermique.

Selon un autre aspect, le condenseur peut être couplé à la première source froide. Dans ce cas, la première source froide et la deuxième source froide sont confondues ou intimement liées. Ainsi, la première source froide permet à la fois la condensation du fluide de travail dans le condenseur et le refroidissement du fluide de travail dans le troisième circuit de communication.

Selon un autre aspect, il est décrit un procédé pour diminuer la température du fluide de travail contenu dans la zone liquide de l'évaporateur du dispositif selon l'une quelconque des revendications précédentes, le procédé comprenant les étapes :
i. augmenter la pression du fluide de travail contenu dans le réservoir au moyen de l'élément d'apport d'énergie, pour produire un écoulement de fluide de travail en phase liquide dans le troisième circuit de communication, en direction de la zone liquide de l'évaporateur,
ii. diminuer la température du fluide de travail circulant dans le troisième circuit de communication en direction de la zone liquide de l'évaporateur, par échange de chaleur avec la première source froide,
dans lequel les étapes i et ii sont réalisées de préférence de manière simultanée.

### Brève description des dessins

D'autres caractéristiques, détails et avantages apparaîtront à la lecture de la description détaillée ci-après, et à l'analyse des dessins annexés, sur lesquels :
La figure 1 représente une vue générale schématique d'un dispositif de transfert thermique ;
La figure 2 représente une vue général schématique d'une variante du dispositif de transfert thermique de la figure 1 ;
La figure 3 représente une vue générale schématique du dispositif de transfert thermique de la figure 1 dans lequel l'élément d'apport d'énergie est en fonctionnement ;
La figure 4 représente une vue schématique du système de commande du dispositif de transfert thermique des figures 1 à 3 ;
La figure 5 représente un chronogramme illustrant le fonctionnement du dispositif de transfert thermique des figures 1 à 3.

### Description des modes de réalisation

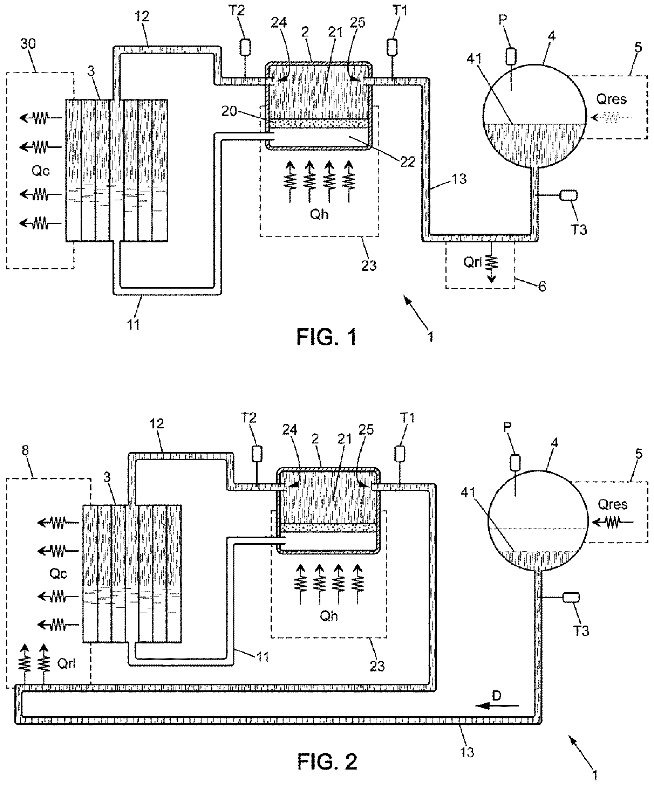

La figure 1 représente un dispositif de transfert thermique 1 à fluide de travail diphasique. Le fluide de travail peut, par exemple, être de l'ammoniac, du méthanol, de l'acétone, de l'eau, de l'éthane, de l'éthanol ou tout autre fluide caloporteur approprié. Le dispositif comprend, généralement, un évaporateur 2 ayant une entrée et une sortie. L'évaporateur 2 comprend par ailleurs une structure capillaire 20 adaptée pour assurer un pompage capillaire. La structure capillaire 20 sépare l'évaporateur 2 entre une zone liquide 21 en communication avec l'entrée de l'évaporateur et une zone vapeur 22 en communication avec la sortie de l'évaporateur. Ici, l'entrée de l'évaporateur 2 forme un premier orifice 24 de la zone liquide 21 de l'évaporateur. Selon un exemple particulier de réalisation, la zone liquide 21 peut former un évidement central borgne entouré par la structure capillaire 20. Selon un autre mode particulier de réalisation, la zone liquide 21 peut notamment former une zone principale et/ou une pluralité de canaux. La zone vapeur peut former une pluralité de canaux séparés par des cloisons de structure capillaire ou de métal ou de colle. La structure capillaire 20 peut être une mèche poreuse ou une masse poreuse.

L'évaporateur 2 est thermiquement couplé à une source chaude 23, par exemple un ensemble comprenant des composants électroniques de puissance ou tout autre élément générant de la chaleur Qh, notamment, par effet Joule, ou par tout autre processus. L'apport de chaleur Qh peut, par exemple, être de l'ordre de 6 à 7 kW.

Sous l'effet de l'apport de chaleur Qh au contact de la structure capillaire 20 emplie de liquide, du fluide de travail passe de l'état liquide à l'état vapeur et s'évacue par la zone vapeur 22 (i.e. ses canaux). Dans la structure capillaire 20 de l'évaporateur 2, l'apport d'énergie sous forme de chaleur Qh, provenant de la source chaude, est transférée à la vapeur formée. Une surface dissipative de la structure capillaire est par ailleurs continument alimentée en fluide de travail en phase liquide; il s'agit du phénomène de pompage capillaire.

Le fluide de travail en phase vapeur est ensuite acheminé, depuis la zone vapeur 22, vers un condenseur 3 à travers un premier circuit de communication 11 comportant une ou plusieurs lignes. Dans l'exemple représenté, le premier circuit de communication 11 comprend une seule ligne. Le condenseur 3 comprend au moins une entrée et au moins une sortie. Le premier circuit de communication 11 relie alors la sortie de l'évaporateur 2 à au moins une entrée du condenseur 3. Dans l'exemple représenté, le condenseur 3 comprend une entrée et une sortie.

A l'intérieur du condenseur 3, de la chaleur Qc est cédée par le fluide de travail en phase vapeur. Cela provoque un refroidissement du fluide de travail et un changement d'état du fluide de travail de la phase vapeur vers la phase liquide. Autrement dit, cela provoque la condensation du fluide de travail.

La pression du fluide de travail en phase vapeur pousse le fluide de travail en phase liquide dans le condenseur 3 vers un deuxième circuit de communication 12. Le deuxième circuit de communication 12 relie la sortie du condenseur 3 à l'entrée de l'évaporateur 2. Le deuxième circuit de communication 12 contient essentiellement du fluide de travail en phase liquide. Le fluide de travail en phase liquide est ainsi acheminé vers la zone liquide 21 de l'évaporateur 2. Le dispositif 1 forme ainsi une boucle diphasique fermée.

Le dispositif comprend en outre un réservoir 4. Le réservoir 4 présente un volume intérieur contenant du fluide de travail. Le fluide de travail contenu dans le réservoir 4 présente une phase vapeur et une phase liquide. La température de la surface de séparation 41 entre la phase liquide et la phase vapeur dans le réservoir 4, appelée température de saturation T_{SAT}, détermine la pression dans la boucle diphasique. Cette pression correspond à la pression de saturation P_{SAT} du fluide de travail à la température prévalant à la surface de séparation en vertu de la relation biunivoque qui relie la pression de saturation et la température de saturation en condition de saturation.

Le réservoir 4 est relié à la zone liquide 21 de l'évaporateur 2 par l'intermédiaire d'un troisième circuit de communication 13. De manière remarquable, le réservoir 4 est uniquement relié à la zone liquide 21 par le troisième circuit de communication 13. Autrement dit, le réservoir 4 est en communication fluidique uniquement avec l'évaporateur 4, dans sa zone liquide 21. Le troisième circuit de communication 13 communique avec la zone liquide 21 de l'évaporateur par l'intermédiaire d'un deuxième orifice 25 de la zone liquide 21. Le troisième circuit de communication est adapté pour un écoulement de fluide de travail, notamment en phase liquide, depuis le réservoir 4 vers la zone liquide 21 de l'évaporateur 2. Un tel agencement permet une flexibilité de conception et d'intégration du dispositif. En effet, le réservoir 4 peut être positionné librement dans le dispositif. Autrement dit, le positionnement du réservoir 4 n'est contraint ni par le positionnement des autres éléments du dispositif, ni par l'orientation du dispositif et la présence ou non de gravité. En particulier, le réservoir 4 peut être positionnée indépendamment par rapport à l'évaporateur 2, notamment le réservoir 4 peut être dans une région thermiquement différente de la région de l'évaporateur 2.

Une portion du troisième circuit de communication 13 est thermiquement couplée à une première source froide 6. La première source froide 6 présente une température inférieure d'au moins 10°C par rapport à la température de saturation du fluide de travail. La première source froide peut fonctionner de manière continue. Ici, la première source froide est thermiquement indépendante d'une deuxième source froide 30 du condenseur. La deuxième source froide 30 du condenseur 3 est la source froide principale d'extraction de l'énergie transférée au fluide de travail par la source chaude. En d'autres termes, la première source froide 6 et la deuxième source froide 30 sont ici distinctes. Ainsi, les sources froides peuvent être respectivement disposées dans des régions thermiquement différentes l'une de l'autre. Aussi, la première source froide 6 peut avoir une température différente de la température de la deuxième source froide 30. La première source froide 6 peut, par exemple, être une plaque froide.

Alternativement, la première source froide 6 et la deuxième source froide 30 peuvent être thermiquement couplées, par exemple par l'intermédiaire d'un pont thermique entre la première source froide et la deuxième source froide.

Alternativement encore, comme représenté à la figure 2, le condenseur 3 et le troisième circuit de communication 13 sont thermiquement couplés à une unique source froide 8. L'encombrement du dispositif peut ainsi être réduit.

Le dispositif comprend en outre un élément d'apport d'énergie 5 à commande sélective. L'élément d'apport d'énergie 5 est adapté pour augmenter la pression du fluide de travail contenu dans le réservoir 4. L'élément d'apport d'énergie 5 est ici un élément de chauffage, par exemple une résistance électrique ou une cellule Peltier.

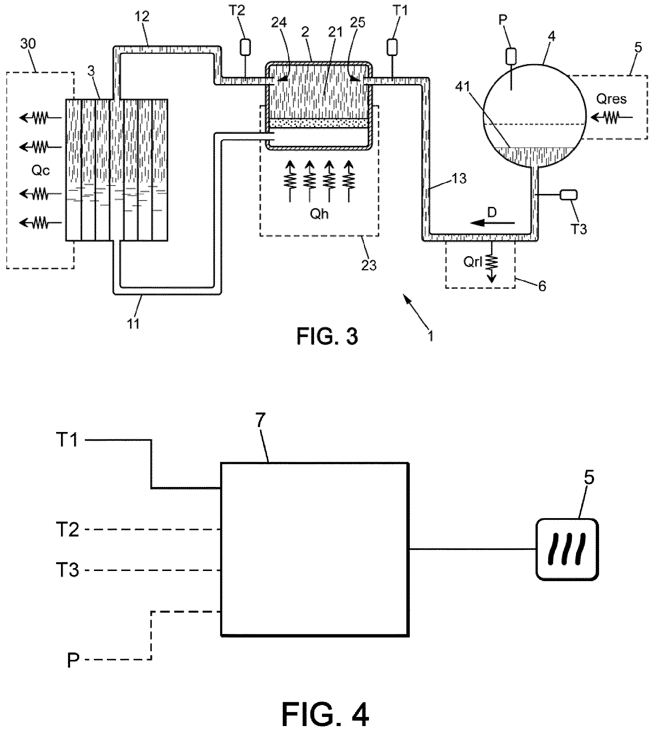

Tel qu'illustré à la figure 3, lorsque l'élément d'apport d'énergie 5 est en fonctionnement, la température du fluide de travail contenu dans le réservoir 4 est augmentée par un apport d'énergie sous forme de chaleur Ores. L'augmentation de la température du fluide de travail contenu dans le réservoir 4 entraine une augmentation de la pression de ce dernier. L'augmentation de pression dans le réservoir 4 produit alors un écoulement de fluide de travail en phase liquide dans le troisième circuit de communication 13, depuis le réservoir 4 vers la zone liquide 21 de l'évaporateur 2. Notamment, l'élément d'apport d'énergie 5 est adapté pour acheminer du liquide, initialement dans le réservoir 4, jusque dans la zone liquide 21 de l'évaporateur. Pour ce faire, Qres peut, par exemple, être pris, en comparaison à Qh, dans un intervalle de valeurs comprises entre 1% et 6% de la valeur de Qh, avantageusement comprises entre 2% et 3% de la valeur de Oh.

Alternativement, l'élément d'apport d'énergie 5 peut être un élément mécanique adapté pour augmenter la pression du fluide dans le réservoir 4 afin de produire le même effet. Par exemple, un tel élément peut être un mécanisme à piston ou encore un mécanisme à diaphragme, comprenant notamment une membrane souple.

Le fluide de travail circulant dans le troisième circuit de communication 13 est ensuite refroidi par un transfert de chaleur Qrl avec la première source froide 6, lorsqu'il circule dans la portion du troisième circuit de communication 13 couplée à la première source froide 6. Le fluide de travail est notamment refroidi pour présenter une température inférieure à la température de saturation du fluide de travail, de préférence une température significativement inférieure à la température de saturation.

Ainsi, du fluide de travail présentant une température inférieure à la température de saturation, est acheminé dans la zone liquide 21 depuis le réservoir 4. De cette manière, lorsque la température du fluide de travail dans la zone liquide 21 est dans un état proche de la saturation ou même dans un état de liquide sur-chauffé, celui-ci est alors refroidi par l'apport de fluide de travail refroidi provenant du réservoir 4 et d'éventuelles bulles de vapeur dans la zone liquide 21 sont condensées.

Aussi, comme décrit précédemment, l'évaporateur et le réservoir peuvent être situés dans des régions thermiquement différentes. Par exemple, l'évaporateur peut être dans un environnement ayant une température de 100°C alors que le réservoir peut être dans un environnement ayant une température de 60°C. Ainsi, il est possible d'imposer des conditions de saturation du fluide de travail dans l'évaporateur à une température de 60°C alors que l'environnement dans lequel se trouve l'évaporateur présente une température de 100°C. En d'autres termes, il est possible de réguler le dispositif de transfert thermique à une température de 60°C alors que l'environnement dans lequel se trouve l'évaporateur présente une température de 100°C. De plus, l'apport de fluide de travail refroidi provenant du réservoir, dans la zone liquide de l'évaporateur, permet de maintenir ces conditions de saturation à 60°C dans l'évaporateur. En effet, sans l'apport de fluide refroidi, il ne serait alors pas possible de maintenir de telles conditions de régulation dans l'évaporateur parce que celui se situe dans un environnement ayant une température supérieure à la température de saturation, dans cet exemple égale à 100°C.

Un tel apport de fluide de travail refroidi, provenant du réservoir, permet, par ailleurs, d'éviter un recours au sous-refroidissement du liquide de travail au niveau du condenseur 3 (« sub-cooling » en anglais) pour refroidir le fluide de travail dans la zone liquide. Cela présente un effet avantageux car pour obtenir un tel sous-refroidissement, la deuxième source froide doit être capable d'extraire plus d'énergie que l'énergie transportée par le fluide pour permettre de diminuer la température du fluide de travail en dessous de la température de saturation. Toutefois, un tel sous-refroidissement au niveau du condenseur requière un surdimensionnement du condenseur, d'une part, et un échange de chaleur monophasique en supplément d'un échange de chaleur diphasique, d'autre part, cela réduisant l'efficacité de la boucle diphasique.

Par ailleurs, le premier orifice 24 est situé au voisinage d'une première extrémité de la zone liquide 21 et le deuxième orifice 25 est situé au voisinage d'une deuxième extrémité de la zone liquide 21. Ainsi, le fluide de travail provenant du condenseur 3 et débouchant dans la zone liquide 21 par l'intermédiaire du deuxième circuit de communication 12, débouche dans une première région de la zone liquide 21 située au voisinage de la première extrémité de la zone liquide 21. De même, le fluide de travail refroidi provenant du troisième circuit de communication 13 débouche dans une deuxième région de la zone liquide 21 située au voisinage de la deuxième extrémité de la zone liquide. La première région et la deuxième région de la zone liquide sont ici opposées. Le refroidissement du fluide de travail dans la zone liquide est ainsi amélioré par rapport à une configuration dans laquelle le fluide de travail provenant du réservoir et le fluide de travail provenant du condenseur débouchent dans la zone liquide par un même raccordement.

Alternativement, le premier orifice 24 et le deuxième orifice 25 peuvent être situés du même côté de la zone liquide 21 de l'évaporateur 2. En particulier, les premier et deuxième orifices 24 et 25 peuvent être adjacents.

Le fonctionnement de l'élément d'apport d'énergie 5 est intermittent. En d'autres termes, l'élément d'apport d'énergie 5 est activé de manière temporaire pour refroidir temporairement le fluide de travail dans la zone liquide 21. En effet, il s'agit de contrôler l'activation de l'élément d'apport d'énergie 5 pour refroidir le fluide de travail dans la zone liquide 21 tout en conservant les performances requises du dispositif de transfert.

La figure 4 représente un schéma du système de commande du dispositif de transfert thermique permettant le pilotage de l'élément d'apport d'énergie 5. A cet effet, le dispositif comprend tout d'abord un premier capteur de température T1 du fluide de travail au voisinage d'une première extrémité du troisième circuit de communication 13, la première extrémité du troisième circuit de communication 13 étant en communication avec la zone liquide 21 de l'évaporateur. Ainsi, la température relevée par le capteur de température T1 est proche, voire égale, à la température du fluide de travail situé au voisinage du deuxième orifice 25 dans la zone liquide 21.

Le dispositif comprend par un ailleurs un circuit électronique 7. Le premier capteur de température T1 est relié au circuit électronique 7. Le circuit électronique 7 est également relié à l'élément d'apport d'énergie 5. Le circuit électronique comprend une logique de commande d'activation de l'élément d'apport d'énergie 5 selon la température relevée par le premier capteur de température T1.

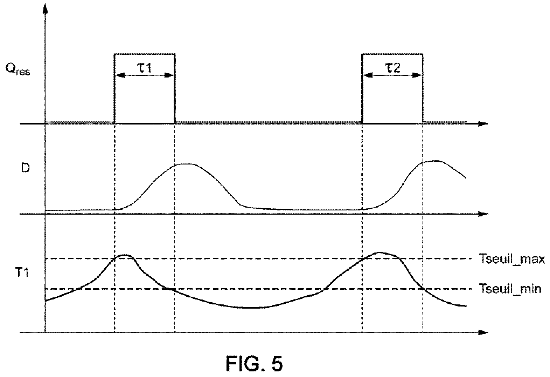

La figure 5 représente un chronogramme d'une telle logique de commande. Lorsque la température relevée par le premier capteur de température T1 est supérieure ou égale à une température seuil maximale Tseuil_max, alors l'élément d'apport d'énergie 5 est activé. Dès lors, une quantité de chaleur Qres est transmise au fluide de travail contenu dans le réservoir 4, formant ainsi un écoulement de fluide de travail dans le troisième circuit de communication 13 en direction de la zone liquide 21 de l'évaporateur 2. L'écoulement de fluide de travail dans le troisième circuit de refroidissement présente un débit D. Le fluide de travail débouchant dans la zone liquide 21 refroidi alors le fluide de travail contenu dans la zone de travail, d'où une diminution de la température relevée par le premier capteur de température T1 en réponse à la formation du débit D. Lorsque la température relevée par le premier capteur de température T1 est inférieure ou égale à une température seuil minimale Tseuil_min, alors l'élément d'apport d'énergie est désactivé. L'élément d'apport d'énergie 5 est activé pendant une première période de temps τ1.

La température du fluide de travail dans la zone liquide 21 peut augmenter à nouveau. Dès lors, l'élément d'apport d'énergie 5 est activé à nouveau pendant une deuxième période de temps τ2. La deuxième période de temps τ2 peut être différente ou égale à la première période de temps τ1.

Le dispositif peut comprendre par ailleurs d'autres capteurs pour améliorer la logique de commande d'activation de l'élément d'apport d'énergie 5, notamment pour déterminer de manière plus précise les instants d'activation et de désactivation de l'élément d'apport d'énergie. De cette manière, la diminution des performances du dispositif par l'augmentation de pression et de température du fluide de travail dans le réservoir sont limitées, voire empêchées.

A cet effet, le dispositif peut comprendre un capteur de pression P du fluide de travail contenu dans le réservoir 4. Il est ainsi possible de déterminer et contrôler le débit D de l'écoulement de fluide de travail produit dans le troisième circuit de communication 13. Par ailleurs, l'indication de pression à l'intérieur du réservoir 4 permet également d'obtenir une indication de température à l'intérieur du réservoir 4 en raison de la relation biunivoque qui relie la pression et la température du fluide de travail en condition de saturation. Une indication de la pression de saturation et de la température de saturation permet alors de déterminer les conditions de fonctionnement du dispositif. Alternativement, il peut être prévu un capteur de température à l'intérieur du réservoir 4.

Le dispositif peut également comprendre un deuxième capteur de température T2 du fluide de travail contenu dans le deuxième circuit de communication 12. Un tel deuxième capteur de température T2 permet notamment de comparer le fluide de travail en phase liquide ayant été refroidi par le condenseur et la température du fluide de travail relevée par le premier capteur de température T1. De cette manière, il est possible d'évaluer la capacité du fluide de travail refroidi provenant du condenseur à diminuer la température du fluide de travail dans la zone liquide.

Le dispositif peut aussi comprendre un troisième capteur de température T3 du fluide de travail au voisinage d'une deuxième extrémité du troisième circuit de communication 13, la deuxième extrémité du troisième circuit de communication étant en communication avec le réservoir.

Par ailleurs, la description et les figures sont dépourvues d'indications de directions en ce que le dispositif est opérable quelle que soit l'orientation de la gravité ou en l'absence de gravité.

## Revendications

1. Dispositif de transfert thermique (1) à fluide de travail diphasique, comprenant :
- un évaporateur (2) comportant une zone liquide (21) et une zone vapeur (22),
- un condenseur (3) ayant au moins une entrée et au moins une sortie,
- un premier circuit de communication (11), pour du fluide de travail essentiellement en phase vapeur, reliant la zone vapeur (22) de l'évaporateur (2) à au moins une entrée du condenseur (3),
- un deuxième circuit de communication (12), pour du fluide de travail essentiellement en phase liquide, reliant au moins une sortie du condenseur (3) à la zone liquide (21) de l'évaporateur (2),
- un réservoir (4) contenant du fluide de travail avec une phase liquide et une phase vapeur,
- un élément d'apport d'énergie (5), à commande sélective, adapté pour augmenter la pression du fluide de travail contenu dans le réservoir (4),
le réservoir étant relié uniquement à l'évaporateur (2), dans sa zone liquide (21), au moyen d'un troisième circuit de communication (13) pour du fluide de travail essentiellement en phase liquide, une portion du troisième circuit de communication étant thermiquement couplée à une première source froide (6).

2. Dispositif selon la revendication 1, dans lequel le deuxième circuit de communication (12) est raccordé à un premier orifice (24) de la zone liquide (21) et le troisième circuit de communication (13) est raccordé à un deuxième orifice (25) de la zone liquide (21), le premier orifice (24) étant situé au voisinage d'une première extrémité de la zone liquide (21) et le deuxième orifice (25) étant situé au voisinage d'une deuxième extrémité de la zone liquide (21).

3. Dispositif selon l'une des revendications 1 ou 2, dans lequel l'évaporateur (2) comporte une structure capillaire (20) séparant la zone liquide (21) de la zone vapeur (22), la structure capillaire (20) étant adaptée au pompage capillaire du fluide de travail en phase liquide.

4. Dispositif selon l'une quelconque des revendications précédentes, dans lequel le fluide de travail est choisi parmi le méthanol, l'acétone, l'eau, l'éthanol, l'éthane, un fluide réfrigérant et l'ammoniac.

5. Dispositif selon l'une quelconque des revendications précédentes, dans lequel l'élément d'apport d'énergie (5) est un élément de **chauffage,** par exemple une résistance électrique ou une cellule Peltier.

6. Dispositif selon l'une quelconque des revendications précédentes, comprenant en outre un premier capteur de température (T1) du fluide de travail au voisinage d'une première extrémité du troisième circuit de communication (13), la première extrémité du troisième circuit de communication (13) étant en communication avec la zone liquide (21) de l'évaporateur (2).

7. Dispositif selon la revendication 6, le dispositif comprenant en outre au moins l'un parmi :
- un capteur de pression (P) du fluide de travail contenu dans le réservoir (4),
- un deuxième capteur de température (T2) du fluide de travail contenu dans le deuxième circuit de communication (12),
- un troisième capteur de température (T3) du fluide de travail au voisinage d'une deuxième extrémité du troisième circuit de communication (13), la deuxième extrémité du troisième circuit de communication (13) étant en communication avec le réservoir (4).

8. Dispositif selon l'une quelconque des revendications précédentes, dans lequel le condenseur (3) est couplé à une deuxième source froide (30), la première source froide (6) étant thermiquement indépendante de la deuxième source froide (30).

9. Dispositif selon l'une quelconque des revendications 1 à 7, dans lequel le condenseur (3) est couplé à une deuxième source froide (30), la première source froide (6) étant thermiquement couplée à la deuxième source froide (30).

10. Procédé pour diminuer la température du fluide de travail contenu dans la zone liquide (21) de l'évaporateur (2) du dispositif selon l'une quelconque des revendications précédentes, le procédé comprenant les étapes :
i. augmenter la pression du fluide de travail contenu dans le réservoir (4) au moyen de l'élément d'apport d'énergie (5), pour produire un écoulement de fluide de travail en phase liquide dans le troisième circuit de communication (13), en direction de la zone liquide (21) de l'évaporateur (2),
ii. diminuer la température du fluide de travail circulant dans le troisième circuit de communication (13) en direction de la zone liquide (21) de l'évaporateur (2), par échange de chaleur avec la première source froide (6),
dans lequel les étapes i et ii sont réalisées de préférence de manière simultanée.

## Patentansprüche

1. Thermische Übertragungsvorrichtung (1) mit zweiphasigem Arbeitsfluid, umfassend:
- einen Verdampfer (2), umfassend eine Flüssigkeitszone (21) und eine Dampfzone (22),
- einen Kondensator (3) mit wenigstens einem Einlass und wenigstens einem Auslass,
- einen ersten Verbindungskreislauf (11) für Arbeitsfluid, das sich im Wesentlichen in der Dampfphase befindet, der die Dampfzone (22) des Verdampfers (2) mit wenigstens einem Einlass des Kondensators (3) verbindet,
- einen zweiten Verbindungskreislauf (12) für sich im Wesentlichen in der flüssigen Phase befindendes Arbeitsfluid, der wenigstens einen Auslass des Kondensators (3) mit der Flüssigkeitszone (21) des Verdampfers (2) verbindet,
- einen Behälter (4), der Arbeitsfluid mit einer flüssigen Phase und einer Dampfphase enthält,
- ein selektiv steuerbares Energiezufuhrelement (5), das dazu geeignet ist, den Druck des in dem Behälter (4) enthaltenen Arbeitsfluids zu erhöhen, wobei der Behälter nur mit dem Verdampfer (2) in dessen Flüssigkeitszone (21) mittels eines dritten Verbindungskreislaufs (13) für im Wesentlichen in der flüssigen Phase befindliches Arbeitsfluid verbunden ist, wobei ein Teil des dritten Verbindungskreislaufs thermisch mit einer ersten Kältequelle (6) gekoppelt ist.

2. Vorrichtung nach Anspruch 1, wobei der zweite Verbindungskreislauf (12) mit einer ersten Öffnung (24) der Flüssigkeitszone (21) verbunden ist und der dritte Verbindungskreislauf (13) mit einer zweiten Öffnung (25) der Flüssigkeitszone (21) verbunden ist, wobei sich die erste Öffnung (24) in der Nähe eines ersten Endes der Flüssigkeitszone (21) befindet und sich die zweite Öffnung (25) in der Nähe eines zweiten Endes der Flüssigkeitszone (21) befindet.

3. Vorrichtung nach einem der Ansprüche 1 oder 2, wobei der Verdampfer (2) eine Kapillarstruktur (20) aufweist, die die Flüssigkeitszone (21) von der Dampfzone (22) trennt, wobei die Kapillarstruktur (20) für das Kapillarpumpen des Arbeitsfluids in der flüssigen Phase ausgelegt ist.

4. Vorrichtung nach einem der vorhergehenden Ansprüche, wobei das Arbeitsfluid aus Methanol, Aceton, Wasser, Ethanol, Ethan, einem Kühlfluid und Ammoniak gewählt ist.

5. Vorrichtung nach einem der vorhergehenden Ansprüche, wobei das Energiezufuhrelement (5) ein **Heizelement,** beispielsweise ein elektrischer Widerstand oder eine Peltier-Zelle, ist.

6. Vorrichtung nach einem der vorhergehenden Ansprüche, welche ferner einen ersten Temperatursensor (T1) für das Arbeitsfluid in der Nähe eines ersten Endes des dritten Verbindungskreislaufs (13) umfasst, wobei das erste Ende des dritten Verbindungskreislaufs (13) mit der Flüssigkeitszone (21) des Verdampfers (2) in Verbindung steht.

7. Vorrichtung nach Anspruch 6, wobei die Vorrichtung ferner wenigstens eines aus Folgendem umfasst:
- einen Drucksensor (P) für das im Behälter (4) enthaltene Arbeitsfluid,
- einen zweiten Temperatursensor (T2) für das im zweiten Verbindungskreislauf (12) enthaltene Arbeitsfluid,
- einen dritten Temperatursensor (T3) für das Arbeitsfluid in der Nähe eines zweiten Endes des dritten Verbindungskreislaufs (13), wobei das zweite Ende des dritten Verbindungskreislaufs (13) mit dem Behälter (4) in Verbindung steht.

8. Vorrichtung nach einem der vorhergehenden Ansprüche, wobei der Kondensator (3) mit einer zweiten Kältequelle (30) gekoppelt ist, wobei die erste Kältequelle (6) thermisch unabhängig von der zweiten Kältequelle (30) ist.

9. Vorrichtung nach einem der Ansprüche 1 bis 7, wobei der Kondensator (3) mit einer zweiten Kältequelle (30) gekoppelt ist, wobei die erste Kältequelle (6) thermisch mit der zweiten Kältequelle (30) gekoppelt ist.

10. Verfahren zur Verringerung der Temperatur des Arbeitsfluids, das in der Flüssigkeitszone (21) des Verdampfers (2) der Vorrichtung nach einem der vorhergehenden Ansprüche enthalten ist, wobei das Verfahren die folgenden Schritte umfasst:
i. Erhöhung des Drucks des im Behälter (4) enthaltenen Arbeitsfluids mittels des Energiezufuhrelements (5), um einen Arbeitsfluidfluss in flüssiger Phase im dritten Verbindungskreislauf (13) in Richtung der Flüssigkeitszone (21) des Verdampfers (2) zu erzeugen,
ii. Verringern der Temperatur des im dritten Verbindungskreislauf (13) in Richtung der Flüssigkeitszone (21) des Verdampfers (2) zirkulierenden Arbeitsfluids durch Wärmeaustausch mit der ersten Kältequelle (6), wobei die Schritte i und ii bevorzugt gleichzeitig durchgeführt werden.

## Claims

1. Two-phase working fluid heat transfer device (1), comprising:
- an evaporator (2) including a liquid zone (21) and a steam zone (22),
- a condenser (3) having at least one inlet and at least one outlet,
- a first communication circuit (11), for working fluid essentially in the vapour phase, connecting the vapour zone (22) of the evaporator (2) to at least one inlet of the condenser (3),
- a second communication circuit (12), for working fluid essentially in the liquid phase, connecting at least one outlet of the condenser (3) to the liquid zone (21) of the evaporator (2),
- a reservoir (4) containing working fluid with a liquid phase and a vapour phase,
- an energy supply element (5), with selective control, adapted to increase the pressure of the working fluid contained in the reservoir (4),
the reservoir being connected only to the evaporator (2), in its liquid zone (21), by means of a third communication circuit (13) for working fluid essentially in liquid phase, a portion of the third communication circuit being thermally coupled to a first cold source (6).

2. Device according to claim 1, wherein the second communication circuit (12) is connected to a first orifice (24) of the liquid zone (21) and the third communication circuit (13) is connected to a second orifice (25) of the liquid zone (21), the first orifice (24) being located in the vicinity of a first end of the liquid zone (21) and the second orifice (25) being located in the vicinity of a second end of the liquid zone (21).

3. Device according to either one of claims 1 or 2, wherein the evaporator (2) includes a capillary structure (20) separating the liquid zone (21) from the vapour zone (22), the capillary structure (20) being adapted for capillary pumping of the working fluid in the liquid phase.

4. Device according to any one of the preceding claims, wherein the working fluid is selected from methanol, acetone, water, ethanol, ethane, a refrigerant fluid, and ammonia.

5. Device according to any one of the preceding claims, wherein the energy supply element (5) is a **heating** element, for example an electrical resistor or a Peltier cell.

6. Device according to any one of the preceding claims, furthermore comprising a first sensor (T1) for the temperature of the working fluid in the vicinity of a first end of the third communication circuit (13), the first end of the third communication circuit (13) being in communication with the liquid zone (21) of the evaporator (2).

7. Device according to claim 6, the device furthermore comprising at least one of:
- a pressure sensor (P) of the working fluid contained in the reservoir (4),
- a second sensor (T2) for the temperature of the working fluid contained in the second communication circuit (12),
- a third sensor (T3) for the temperature of the working fluid in the vicinity of a second end of the third communication circuit (13), the second end of the third communication circuit (13) being in communication with the reservoir (4).

8. Device according to any one of the preceding claims, wherein the condenser (3) is coupled to a second cold source (30), the first cold source (6) being thermally independent of the second cold source (30).

9. Device according to any one of claims 1 to 7, wherein the condenser (3) is coupled to a second cold source (30), the first cold source (6) being thermally coupled to the second cold source (30).

10. Method for lowering the temperature of the working fluid contained in the liquid zone (21) of the evaporator (2) of the device according to any one of the preceding claims, the method comprising the steps of: i. increasing the pressure of the working fluid contained in the reservoir (4) by means of the energy supply element (5), to produce a flow of liquid-phase working fluid in the third communication circuit (13), toward the liquid zone (21) of the evaporator (2),
ii. decreasing the temperature of the working fluid circulating in the third communication circuit (13) toward the liquid zone (21) of the evaporator (2), by heat exchange with the first cold source (6),
wherein steps i and ii are preferably performed simultaneously.
